# EUROPEAN PATENT SPECIFICATION

(11) **EP 4 106 175 B1**
(45) Date of publication and mention of the grant of the patent: **18.02.2026**
(21) Application number: 21822370.9
(22) Date of filing: 31.05.2021
(51) Int. Cl.: H02M 1/32, H02M 7/00, H02M 7/5387, H05K 1/02, H05K 7/14, H05K 7/20, H05K 1/14

(54) **MOTOR CONTROLLER AND VEHICLE**
MOTORSTEUERUNG UND FAHRZEUG
DISPOSITIF DE COMMANDE DE MOTEUR ET VÉHICULE

(30) Priority: 10.06.2020 CN 202010524940
(43) Date of publication of application: 21.12.2022
(73) Proprietor: China Faw Co., Ltd., Changchun, Jilin 130011 (CN)
(72) Inventor: ZHONG, Hua, Changchun, Jilin 130011 (CN); WANG, Deping, Changchun, Jilin 130011 (CN); LIU, Zhiqiang, Changchun, Jilin 130011 (CN); ZHAO, Huichao, Changchun, Jilin 130011 (CN); XU, Decai, Changchun, Jilin 130011 (CN); WANG, Yu, Changchun, Jilin 130011 (CN)
(74) Representative: Dehns Germany Partnerschaft mbB
(86) International application number: PCT/CN2021/097164
(87) International publication number: WO 2021/249221

(56) References cited:
- CN-A- 108 417 542
- CN-A- 108 417 542
- CN-A- 110 254 247
- CN-A- 110 311 595
- CN-A- 110 411 403
- CN-A- 111 697 846
- CN-U- 208 754 619
- CN-U- 208 754 619
- CN-U- 209 072 352
- CN-U- 213 151 945

## Description

### Technical Field

The disclosure relates to the technical field of inverters, and in particular to a motor control unit and a vehicle.

### Background

The motor controller converts Alternating Current (AC) and Direct Current (DC) through power switching devices, and then realizes the control of motor speed and torque.

While a low-current-power device can no longer satisfy a system performance requirement of the motor control unit, a high-power motor control unit is frequently used for its currents as high as hundreds of amperes. The high-power device module includes a plurality of low-current power devices connected in parallel. However, since the number of power devices in each power device module is fixed, it is difficult to select the just right power device module according to a system power level, which is not conducive to cost control. In addition, a fixed shape of the power device module and a limited layout of a power module group on a power circuit board are not conducive to a rational layout and size reduction.

D1 (CN110254247A) discloses a Half-bridge Power Module Assembly, Motor Controller Power Pack, and Electric Vehicle, and D2 (CN108417542 A) discloses a Power Unit Assembly for Motor Controller; however the problem in the related art still remain. Further relevant prior art can be found in CN209072352U.

### Summary

The disclosure provides a motor control unit comprising the features of claim 1 and a vehicle comprising the features of claim 6. By utilizing the teaching of the invention, it is possible to achieve cost control, a rational layout and size reduction.

Advantageous embodiments are the subject matter of the dependent claims

As an example embodiment, each of the U-phase copper bar, the V-phase copper bar and the W-phase copper bar includes a first electrically-conductive structure and a second electrically-conductive structure that are integrally formed, and the first electrically-conductive structures are perpendicular to the second electrically-conductive structures;
the first electrically-conductive structures are at least partially buried in the circuit board, and the second electrically-conductive structures are exposed outside the circuit board; and the second electrically-conductive structures are provided with first threaded holes, and the second electrically-conductive structures are electrically connected to bolts of an electric motor by means of the first threaded holes.

As an example embodiment, the power circuit board further includes current sensors, and the current sensors are arranged on the second electrically-conductive structures in a sleeving manner.

As an example embodiment, the motor control unit further includes a first thermally-conductive and insulating pad, and the first thermally-conductive and insulating pad is located between the radiator and the power circuit board.

As an example embodiment, the first lugs are provided with first fixing holes, and the second lugs are provided with second fixing holes; the fourth electrically-conductive structures are provided with third fixing holes;
the first copper bars are fixed to the first lugs by means of bolts penetrating the first fixing holes and the third fixing holes; and
the second copper bars are fixed to the second lugs by means of bolts penetrating the second fixing holes and the third fixing holes.

Furthermore, the vehicle includes the motor control unit described in any of embodiments of the disclosure.

### Brief Description of the Drawings

Fig. 1 is an exploded view of a motor control unit provided in an embodiment of the disclosure;
Fig. 2 is a structural schematic diagram of a power circuit board provided in an embodiment of the disclosure;
Fig. 3 is an exploded view of a power circuit board provided in an embodiment of the disclosure;
Fig. 4 is a topological schematic diagram of a power unit provided in an embodiment of the disclosure.

### Detailed Description of the Embodiments

The disclosure will be described below with reference to accompanying drawings and in conjunction with embodiments. The embodiments described herein are merely used to explain the disclosure, but not limit the disclosure. For the convenience of description, some rather than all of structures related to the disclosure are merely shown in the accompanying drawings.

The terms used in the embodiments of the disclosure are merely to describe the specific embodiments, instead of limiting the disclosure. The orientation terms such as "upper", "lower", "left" and "right" described in the embodiments of the disclosure are described from the angle shown in the accompanying drawings, and should not be construed as limiting the embodiments of the disclosure. In addition, in the context, when it is mentioned that an element is formed at an "upper" or "lower" portion of another element, it can not only be directly formed at the "upper" or "lower" portion of the another element, but also indirectly formed at the "upper" or "lower" portion of the another element via an intermediate element. The terms such as "first" and "second" are merely used for description and do not indicate any order, amount or importance, but are merely used to distinguish different components. The meanings of the above terms in the disclosure could be understood according to specific circumstances.

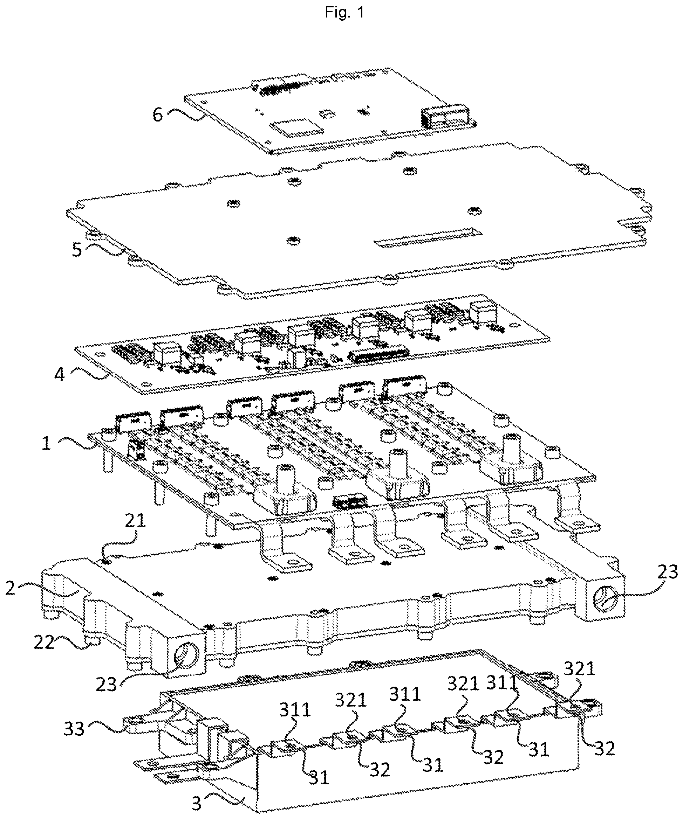

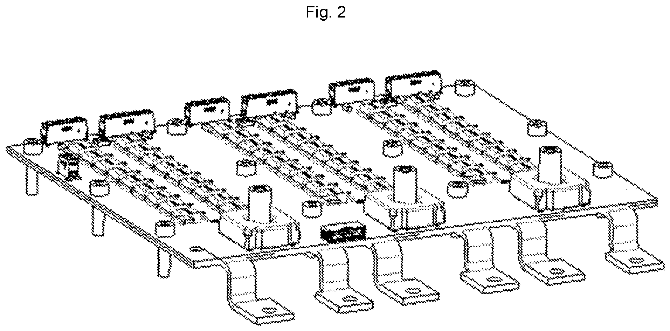

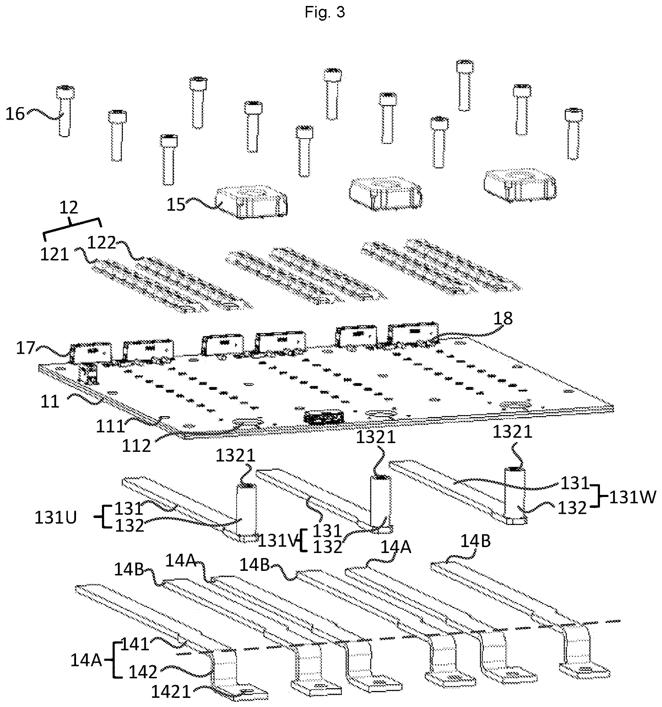

Fig. 1 is an exploded view of a motor control unit provided in an embodiment of the disclosure. Fig. 2 is a structural schematic diagram of a power circuit board provided in an embodiment of the disclosure. Fig. 3 is an exploded view of a power circuit board provided in an embodiment of the disclosure. With reference to Figs. 1-3, a motor control unit includes a power circuit board 1, where the power circuit board 1 includes a circuit board 11 and a plurality of bridge arms 12; the circuit board 11 includes a mounting surface and a non-mounting surface that are arranged oppositely, and the bridge arms 12 are arranged on a plane where the mounting surface is located; each of the bridge arms 12 includes an upper bridge arm 121 and a lower bridge arm 122, and each of the upper bridge arms 121 and the lower bridge arms 122 includes a plurality of discrete power tubes; the power circuit board 1 further includes a plurality of first copper bars 14A and a plurality of second copper bars 14B that are buried in the circuit board 11; the first copper bars 14A correspond to the upper bridge arms 121 one to one, and the first copper bar 14A is electrically connected to first poles of the plurality of power tubes in the same upper bridge arm 121; the second copper bars 14B correspond to the lower bridge arms 122 one to one, and the second copper bar 14B is electrically connected to second poles of the plurality of power tubes in the same lower bridge arm 122; and the power circuit board 1 further includes a U-phase copper bar 131U, a V-phase copper bar 131V and a W-phase copper bar 131W that are buried in the circuit board 11 and configured to output a three-phase alternating current. The circuit board 11 includes a circuit base board, and the bridge arms 12 may be half-bridge.

With further reference to Fig 1, the motor control unit further includes a control circuit board 6, a shielding plate 5 and a driving circuit board 4, implementations of which may be set according to actual conditions and related technologies and are not limited herein. As an example embodiment, the control circuit board 6 may be fixed to the shielding plate 5 by means of a bolt, and the driving circuit board 4 may be fixed to the other side of the shielding plate 5 by means of a bolt, such that a mounting process is simple, which improves mounting efficiency advantageously.

Fig. 1 merely shows that three bridge arms 12 are arranged on the power circuit board 1 for example, but does not limit the disclosure, and the number of bridge arms 12 may be set according to the actual conditions. To describe connection of the U-phase copper bar 131U, the V-phase copper bar 131V and the W-phase copper bar 131W with the power tubes, an example in which three bridge arms 12 are arranged on the power circuit board 1 is described below. For example, each of the U-phase copper bar 131U, the V-phase copper bar 131V and the W-phase copper bar 131W corresponds to a bridge arm 12, and the U-phase copper bar 131U is electrically connected to the second poles of the plurality of power tubes in the corresponding upper bridge arm 121, and is electrically connected to the first poles of the plurality of power tubes in the corresponding lower bridge arm 122; the V-phase copper bar 131V is electrically connected to the second poles of the plurality of power tubes in the corresponding upper bridge arm 121, and is electrically connected to the first poles of the plurality of power tubes in the corresponding lower bridge arm 122; and the W-phase copper bar 131W is electrically connected to the second poles of the plurality of power tubes in the corresponding upper bridge arm 121, and is electrically connected to the first poles of the plurality of power tubes in the corresponding lower bridge arm 122. When other numbers of bridge arms 12 are arranged on the power circuit board 1 the U-phase copper bar 131U, the V-phase copper bar 131V and the W-phase copper bar 131W may be connected to the power tubes according to the actual conditions, so as to output the three-phase alternating current.

In a manufacturing process of the circuit board 11, the first copper bars 14A, the second copper bars 14B, the U-phase copper bar 131U, the V-phase copper bar 131V and the W-phase copper bar 131W are pre-buried in the circuit board 11, that is, the plurality of copper bars and the circuit board 11 are integrally formed, such that assembly steps of the plurality of copper bars and the circuit board 11 may be omitted. In addition, compared with a manner that the copper bars are connected to the circuit board 11 by bolts, a manner of pre-burying the copper bars may make a connection manner between the copper bars and the circuit board 11 more reliable, thereby ensuring optimal electrical connection between the plurality of copper bars and the circuit board 11 in a vibration environment and improving shock resistance. The first copper bars 14A are connected to a positive direct current bus, the second copper bars 14B are connected to a negative direct current bus, and the U-phase copper bar 131U, the V-phase copper bar 131V and the W-phase copper bar 131W are configured to output the three-phase alternating current. In an embodiment, the first copper bars 14A, the second copper bars 14B, the U-phase copper bar 131U, the V-phase copper bar 131V and the W-phase copper bar 131W that are buried in the circuit board 11 are capable of carrying high currents, so as to enhance current-carrying capability of the power circuit board 1 advantageously.

In an embodiment, metal oxide semiconductor field effect transistors (MOSFETs), insulated gate bipolar transistors (IGBTs), or other known types of power tubes may be used as the power tubes, which are not limited herein. As an example embodiment, the power tubes may be arranged on the circuit board 11 through a welding manner, optionally, with further reference to Fig. 2, the plurality of power tubes are arranged on the circuit board 11 in rows, such that a layout is rational and power expandability is desirable.

With further reference to Fig. 3, the power circuit board 1 may further include a protective circuit 18, a signal terminal 17 and an absorption circuit. The protective circuit 18 is configured to protect safe and reliable operations of the power tubes, the signal terminal 17 is configured to interact with a signal of the driving circuit board 4, and the absorption circuit is configured to absorb a voltage spike and a current spike caused by stray inductance in a power circuit, thereby improving system performance and enhancing an electromagnetic compatibility level of a system.

According to the motor control unit provided in the embodiment of the disclosure, a function of a high-power device is achieved by connecting discrete power switch devices in parallel, such that the number of parallel-connected power switch devices in the high-power device may be flexibly controlled according to a system power level, thereby controlling cost. Moreover, a plurality of discrete switch devices may be rationally laid out according to a size requirement of the motor control unit and a distribution condition of other devices on the power circuit board, such that the problems that the cost is difficult to control and the rational layout is hard to achieve due to use of a power device module are solved, and the effects of cost control, a rational layout and size reduction according to the system power level are achieved.

Based on the technical solution, with further reference to Figs. 2 and 3, optionally, each of the U-phase copper bar 131U, the V-phase copper bar 131V and the W-phase copper bar 131W includes a first electrically-conductive structure 131 and a second electrically-conductive structure 132 that are integrally formed, or each of the U-phase copper bar 131U, the V-phase copper bar 131V and the W-phase copper bar 131W includes a first electrically-conductive structure 131 and a second electrically-conductive structure 132 that are welded into a whole, and the first electrically-conductive structures 131 are perpendicular to the second electrically-conductive structures 132. The first electrically-conductive structures 131 are at least partially buried in the circuit board 11, and the second electrically-conductive structures 132 are exposed outside the circuit board 11. The second electrically-conductive structures 132 are provided with first threaded holes 1321, and the second electrically-conductive structures 132 are electrically connected to bolts of an electric motor by means of the first threaded holes 1321.

The circuit board 11 may be provided with first through holes 112, and the second electrically-conductive structures 132 pass through the circuit board 11 via the first through holes 112 and are exposed outside the circuit board 11.

When the motor control unit is electrically connected to the electric motor, a bolt connected to a U-phase current input end of an electrode may match a first threaded hole 1321 on the U-phase copper bar 131U, a bolt connected to a V-phase current input end of the electrode may match a first threaded hole 1321 on the V-phase copper bar 131V, and a bolt connected to a W-phase current input end of the electrode may match a first threaded hole 1321 on the W-phase copper bar 131W.

Compared with a manner that the first electrically-conductive structures 131 are connected to the second electrically-conductive structures 132 by bolts, the first electrically-conductive structures 131 and the second electrically-conductive structures 132 are integrally formed or welded into a whole, which reduces the assembly steps advantageously, so as to ensure the optimal electrical connection between the first electrically-conductive structures 131 and the second electrically-conductive structures 132 in the vibration environment, and improve the shock resistance.

With further reference to Figs. 2 and 3, optionally, the power circuit board 1 further includes current sensors 15, and the current sensors 15 are arranged on the second electrically-conductive structures 132 in a sleeving manner.

The current sensors 15 may be a Hall current sensor 15 or other known current sensors 15. Each of the U-phase copper bar 131U, the V-phase copper bar 131V and the W-phase copper bar 131W is sleeved with at least one current sensor 15. In an embodiment, the current sensor 15 matches the U-phase copper bar 131U, the V-phase copper bar 131V or the W-phase copper bar 131W in a sleeving manner, with a simple assembly method, so as to improve assembly efficiency advantageously.

With further reference to Fig 1, the motor control unit further includes a radiator 2 and the radiator 2 is arranged at one side of the circuit board 11 away from the bridge arms 12. Lower surfaces of the first copper bars 14A, lower surfaces of the second copper bars 14B, a lower surface of the U-phase copper bar 131U, a lower surface of the V-phase copper bar 131V and a lower surface of the W-phase copper bar 131W all face the radiator 2 and are located in a same plane as the non-mounting surface of the circuit board 11.

In an embodiment, the radiator 2 may be achieved in a form of a radiation fin or other known forms, which is not limited herein. According to the actual conditions, air cooling and/or water cooling may be used, which is not limited herein. For example, Fig. 1 shows that the radiator is provided with a water cooling channel 23 so as to facilitate water cooling and heat dissipation.

The power tubes are arranged on the first copper bars 14A, the second copper bars 14B, the U-phase copper bar 131U, the V-phase copper bar 131V and the W-phase copper bar 131W, such that heat generated by power tube loss may be transferred to the copper bars, the lower surfaces of the copper bars are exposed and close to the radiator 2, and then the heat generated by the power tube loss may be transferred to the radiator 2 via the copper bars for heat dissipation. In this way, timely circulation of heat is facilitated, and overall heat-dissipation capability of the power circuit board 1 is enhanced.

In an embodiment, the circuit board 11 may be provided with a fourth fixing hole 111, and accordingly, the radiator 2 may be provided with a second threaded hole 21, and the power circuit board 1 is fixed to the radiator 2 by means of a fixing bolt 16 penetrating the fourth fixing hole 111 and the second threaded hole 21. Fig. 1 merely shows that the number of fourth fixing holes 111 or second threaded holes 21 is 12 for example, which does not limit the disclosure, and the number may be set according to the actual conditions.

As an example embodiment, the motor control unit further includes a first thermally-conductive and insulating pad, and the first thermally-conductive and insulating pad is located between the radiator 2 and the power circuit board 1.

In an embodiment, an upper surface of the first thermally-conductive and insulating pad makes contact with the non-mounting surface of the power circuit board 1, and a lower surface of the first thermally-conductive and insulating pad makes contact with a surface of the radiator 2 facing the power circuit board 1. On the one hand, the first thermally-conductive and insulating pad is capable of conducting heat and conveniently conducting heat on the power circuit board 1 to the radiator 2, thereby enhancing the heat-dissipation capability; and on the other hand, the first thermally-conductive and insulating pad has an insulation function and may ensure that the power circuit board 1 is insulating and voltage-withstanding, thereby making reliability of the power circuit board 1 higher.

With further reference to Fig. 1, the motor control unit further includes a capacitor 3 and the capacitor 3 is arranged at one side of the radiator 2 away from the power circuit board 1. Optionally, a second thermally-conductive and insulating pad (as shown in the figure) is arranged between the radiator 2 and the capacitor 3. In an embodiment, an upper surface of the second thermally-conductive and insulating pad makes contact with a surface of the radiator 2 away from the power circuit board 1, and a lower surface of the second thermally-conductive and insulating pad makes contact with a surface of the capacitor 3 facing the radiator 2.

The power circuit board 1 and the capacitor 3 are arranged on two sides of the radiator 2 respectively, such that the radiator 2 may dissipate heat not only for the power circuit board 1, but also for the capacitor 3, so as to improve the overall heat-dissipation capability of the motor control unit advantageously.

The capacitor 3 is an integrated thin-film capacitor 3.

Compared with a plurality of discrete capacitors 3, integrated thin-film capacitors 3 may make the capacitors 3 have a more compact structure, better electrical performance and better shock resistance.

With further reference to Fig. 1, one side of a packaging shell of the integrated thin-film capacitor 3 is provided with a plurality of protruding first lugs 31 and a plurality of protruding second lugs 32, the first lugs 31 are electrically connected to a first end of the integrated thin-film capacitor 3, and the second lugs 32 are electrically connected to a second end of the integrated thin-film capacitor 3; each of the first copper bars 14A and the second copper bars 14B includes a third electrically-conductive structure 141 and a fourth electrically-conductive structure 142 that are integrally formed, or each of the first copper bars 14A and the second copper bars 14B includes a third electrically-conductive structure 141 and a fourth electrically-conductive structure 142 that are welded integrally; the third electrically-conductive structures 141 are at least partially buried in the circuit board 11, and the fourth electrically-conductive structures 142 are exposed outside the circuit board 11; the first copper bars 14A correspond to the first lugs 31 one to one, and the fourth electrically-conductive structures 142 of the first copper bars 14A at least partially abut against the first lugs 31; and the second copper bars 14B correspond to the second lugs 32 one to one, and the fourth electrically-conductive structures 142 of the second copper bars 14B at least partially abut against the second lugs 32.

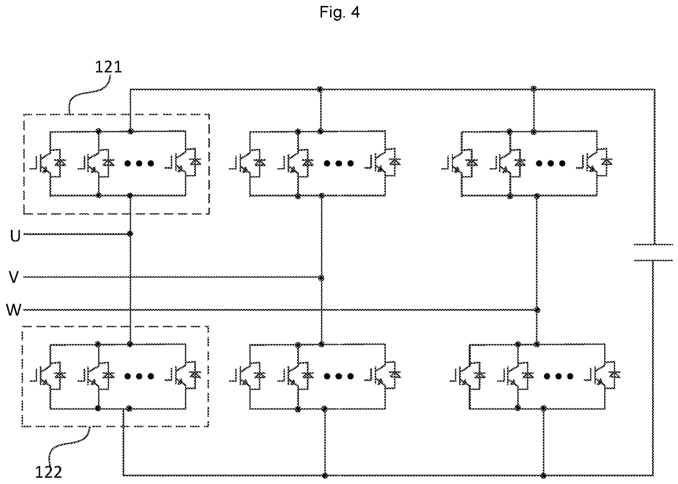

For example, Fig. 4 is a topological schematic diagram of a power unit provided in an embodiment of the disclosure, and the power unit includes a three-phase bridge arm and the capacitor 3. A first end of the capacitor 3 is electrically connected to the power tubes in the upper bridge arms 121 by means of the first lugs 31 and the first copper bars 14A, and a second end of the capacitor 3 is electrically connected to the power tubes in the lower bridge arms 122 by means of the second lugs 32 and the second copper bars 14B.

In an embodiment, shapes of the fourth electrically-conductive structures 142, the first lugs 31 and the second lugs 32 may be set according to the actual conditions, which are not limited herein. For example, as shown in Figs. 1 and 3, the fourth electrically-conductive structures 142 may be L-shaped, and the first lugs 31 and the second lugs 32 may be stepped.

Compared with a manner that the third electrically-conductive structures 141 are connected to the fourth electrically-conductive structures 142 by bolts, the third electrically-conductive structures 141 and the fourth electrically-conductive structures 142 are integrally formed or welded into a whole, which reduces the assembly steps advantageously, so as to ensure the optimal electrical connection between the third electrically-conductive structures 141 and the fourth electrically-conductive structures 142 in the vibration environment, and improve the shock resistance.

To distinguish the third electrically-conductive structures 141 from the fourth electrically-conductive structures 142, in Fig. 3, dotted lines are drawn at junctions of the third electrically-conductive structures 141 and the fourth electrically-conductive structures 142, which are not solid structures.

With further reference to Fig. 1, optionally, the first lugs 31 are provided with first fixing holes 311, and the second lugs 32 are provided with second fixing holes 321; the fourth electrically-conductive structures 142 are provided with third fixing holes 1421; the first copper bars 14A are fixed to the first lugs 31 by means of bolts penetrating the first fixing holes 311 and the third fixing holes 1421; and the second copper bars 14B are fixed to the second lugs 32 by means of bolts penetrating the second fixing holes 321 and the third fixing holes 1421. In this way, assembly of the power circuit board 1 and the capacitor 3 may be achieved, reliable contact and electrical connection between the first copper bars 14A and the first lugs 31 may be ensured, and reliable contact and electrical connection between the second copper bars 14B and the second lugs 32 may be ensured, thereby improving the shock resistance.

In an embodiment, the packaging shell of the integrated thin-film capacitor 3 may be further provided with a fifth fixing hole 33, the radiator 2 may be provided with a third threaded hole 22, and the integrated thin-film capacitor 3 is fixed to the radiator 2 by means of a bolt penetrating the fifth fixing hole 33 and the third threaded hole 22.

Based on the above concept, an embodiment of the disclosure further provides a vehicle, which includes any of the motor control units described above, and accordingly, the vehicle has corresponding functions and effects, which will not be repeated herein.

## Claims

1. A motor control unit, comprising a power circuit board (1), wherein the power circuit board (1) comprises a circuit board (11) and a plurality of bridge arms (12); the circuit board (11) comprises a mounting surface and a non-mounting surface that are arranged oppositely, and the plurality of bridge arms (12) are arranged on a plane where the mounting surface is located;
each of the bridge arms (12) comprises an upper bridge arm (121) and a lower bridge arm (122), and each of the upper bridge arms (121) and each of the lower bridge arms (122) comprises a plurality of discrete power tubes;
the power circuit board (1) further comprises a plurality of first copper bars (14A) and a plurality of second copper bars (14B) that are buried in the circuit board (11); the first copper bars (14A) correspond to the upper bridge arms (121), and the first copper bar (14A) is electrically connected to first poles of the plurality of power tubes in the same upper bridge arm (121); the second copper bars (14B) correspond to the lower bridge arms (122) one to one, and the second copper bar (14B) is electrically connected to second poles of the plurality of power tubes in the same lower bridge arm (122); and
the power circuit board (1) further comprises a U-phase copper bar (131U), a V-phase copper bar (131V) and a W-phase copper bar (131W) that are buried in the circuit board (11) and configured to output a three-phase alternating current;
the motor control unit further comprising a radiator (2), wherein the radiator (2) is arranged at one side of the circuit board (11) away from the bridge arms (12); and lower surfaces of the first copper bars (14A), lower surfaces of the second copper bars (14B), a lower surface of the U-phase copper bar (131U), a lower surface of the V-phase copper bar (131V) and a lower surface of the W-phase copper bar (131W) all face the radiator (2) and are located in a same plane as the non-mounting surface of the circuit board (11);
the motor control unit further comprising a capacitor (3), wherein the capacitor (3) is arranged at one side of the radiator (2) away from the power circuit board (1), and the capacitor (3) is an integrated thin-film capacitor (3);
wherein one side of a packaging shell of the integrated thin-film capacitor (3) is provided with a plurality of protruding first lugs (31) and a plurality of protruding second lugs (32), the first lugs (31) are electrically connected to a first end of the integrated thin-film capacitor (3), and the second lugs (32) are electrically connected to a second end of the integrated thin-film capacitor (3);
each of the first copper bars (14A) and the second copper bars (14B) comprises a third electrically-conductive structure (141) and a fourth electrically-conductive structure (142) that are integrally formed; the third electrically-conductive structures (141) are at least partially buried in the circuit board (11), and the fourth electrically-conductive structures (142) are exposed outside the circuit board (11);
the first copper bars (14A) correspond to the first lugs (31) one to one, and the fourth electrically-conductive structures (142) of the first copper bars (14A) at least partially abut against the first lugs (31); and
the second copper bars (14B) correspond to the second lugs (32) one to one, and the fourth electrically-conductive structures (142) of the second copper bars (14B) at least partially abut against the second lugs (32).

2. The motor control unit according to claim 1, wherein each of the U-phase copper bar (131U), the V-phase copper bar (131V) and the W-phase copper bar (131W) comprises a first electrically-conductive structure (131) and a second electrically-conductive structure (132) that are integrally formed, and the first electrically-conductive structures (131) are perpendicular to the second electrically-conductive structures (132);
the first electrically-conductive structures (131) are at least partially buried in the circuit board (11), and the second electrically-conductive structures (132) are exposed outside the circuit board (11); and the second electrically-conductive structures (132) are provided with first threaded holes (1321), and the second electrically-conductive structures (132) are electrically connected to bolts of an electric motor by means of the first threaded holes (1321).

3. The motor control unit according to claim 2, wherein the power circuit board (1) further comprises current sensors (15), and the current sensors (15) are arranged on the second electrically-conductive structures (132) in a sleeving manner.

4. The motor control unit according to claim 1, further comprising a first thermally-conductive and insulating pad, wherein the first thermally-conductive and insulating pad is located between the radiator (2) and the power circuit board (1).

5. The motor control unit according to claim 8, wherein the first lugs (31) are provided with first fixing holes (311), and the second lugs (32) are provided with second fixing holes (321); the fourth electrically-conductive structures (142) are provided with third fixing holes (1421);
the first copper bars (14A) are fixed to the first lugs (31) by means of bolts penetrating the first fixing holes (311) and the third fixing holes (1421); and
the second copper bars (14B) are fixed to the second lugs (32) by means of bolts penetrating the second fixing holes (321) and the third fixing holes(1421).

6. A vehicle, comprising the motor control unit according to any one of claims 1-5.

## Patentansprüche

1. Motorsteuereinheit, umfassend eine Leistungsschaltungsplatine (1), wobei die Leistungsschaltungsplatine (1) eine Platine (11) und eine Vielzahl von Brückenzweigen (12) umfasst; die Platine (11) eine Montagefläche und eine Nicht-Montagefläche umfasst, die einander gegenüberliegend angeordnet sind, und die Vielzahl von Brückenzweigen (12) auf einer Ebene angeordnet sind, auf der sich die Montagefläche befindet;
wobei jeder der Brückenzweige (12) einen oberen Brückenzweig (121) und einen unteren Brückenzweig (122) umfasst, und jeder der oberen Brückenzweige (121) und jeder der unteren Brückenzweige (122) eine Vielzahl von diskreten Leistungshalbleitern bzw. Powertubes umfasst;
die Leistungsschaltungsplatine (1) ferner eine Vielzahl von ersten Kupferstangen (14A) und eine Vielzahl von zweiten Kupferstangen (14B) umfasst, die in der Platine (11) eingebettet sind; die ersten Kupferstangen (14A) den oberen Brückenzweigen (121) entsprechen, und die erste Kupferstange (14A) elektrisch mit ersten Polen der Vielzahl von Leistungshalbleitern im selben oberen Brückenzweig (121) verbunden ist; die zweiten Kupferstangen (14B) den unteren Brückenzweigen (122) eins zu eins entsprechen, und die zweite Kupferstange (14B) elektrisch mit zweiten Polen der Vielzahl von Leistungshalbleitern im selben unteren Brückenzweig (122) verbunden ist; und
die Leistungsschaltungsplatine (1) ferner eine U-Phasen-Kupferstange (131U), eine V-Phasen-Kupferstange (131V) und eine W-Phasen-Kupferstange (131W) umfasst, die in der Platine (11) eingebettet und dazu ausgelegt sind, einen dreiphasigen Wechselstrom auszugeben;
die Motorsteuereinheit ferner umfassend einen Kühlkörper (2), wobei der Kühlkörper (2) auf einer Seite der Platine (11) angeordnet ist, die von den Brückenzweigen (12) abgewandt ist; und untere Flächen der ersten Kupferstangen (14A), untere Flächen der zweiten Kupferstangen (14B), eine untere Fläche der U-Phasen-Kupferstange (131U), eine untere Fläche der V-Phasen-Kupferstange (131V) und eine untere Fläche der W-Phasen-Kupferstange (131W) alle dem Kühlkörper (2) zugewandt sind und sich in derselben Ebene wie die Nicht-Montagefläche der Platine (11) befinden;
die Motorsteuereinheit ferner umfassend einen Kondensator (3), wobei der Kondensator (3) auf einer Seite des Kühlkörpers (2) angeordnet ist, die von der Leistungsschaltungsplatine (1) abgewandt ist, und der Kondensator (3) ein integrierter Dünnschichtkondensator (3) ist;
wobei eine Seite eines Gehäuses des integrierten Dünnschichtkondensators (3) mit einer Vielzahl von vorstehenden ersten Laschen (31) und einer Vielzahl von vorstehenden zweiten Laschen (32) versehen ist, die ersten Laschen (31) elektrisch mit einem ersten Ende des integrierten Dünnschichtkondensators (3) verbunden sind, und die zweiten Laschen (32) elektrisch mit einem zweiten Ende des integrierten Dünnschichtkondensators (3) verbunden sind;
jede der ersten Kupferstangen (14A) und der zweiten Kupferstangen (14B) eine dritte elektrisch leitende Struktur (141) und eine vierte elektrisch leitende Struktur (142) umfasst, die einstückig ausgebildet sind; die dritten elektrisch leitenden Strukturen (141) zumindest teilweise in der Platine (11) eingebettet sind, und die vierten elektrisch leitenden Strukturen (142) außerhalb der Platine (11) freiliegen;
die ersten Kupferstangen (14A) den ersten Laschen (31) eins zu eins entsprechen, und die vierten elektrisch leitenden Strukturen (142) der ersten Kupferstangen (14A) zumindest teilweise an den ersten Laschen (31) anliegen; und
die zweiten Kupferstangen (14B) den zweiten Laschen (32) eins zu eins entsprechen, und die vierten elektrisch leitenden Strukturen (142) der zweiten Kupferstangen (14B) zumindest teilweise an den zweiten Laschen (32) anliegen.

2. Motorsteuereinheit nach Anspruch 1, wobei jede der U-Phasen-Kupferstange (131U), der V-Phasen-Kupferstange (131V) und der W-Phasen-Kupferstange (131W) eine erste elektrisch leitende Struktur (131) und eine zweite elektrisch leitende Struktur (132) umfasst, die einstückig ausgebildet sind, und die ersten elektrisch leitenden Strukturen (131) senkrecht zu den zweiten elektrisch leitenden Strukturen (132) sind;
die ersten elektrisch leitenden Strukturen (131) zumindest teilweise in der Platine (11) eingebettet sind, und die zweiten elektrisch leitenden Strukturen (132) außerhalb der Platine (11) freiliegen; und die zweiten elektrisch leitenden Strukturen (132) mit ersten Gewindelöchern (1321) versehen sind, und die zweiten elektrisch leitenden Strukturen (132) über die ersten Gewindelöcher (1321) elektrisch mit Schrauben eines Elektromotors verbunden sind.

3. Motorsteuereinheit nach Anspruch 2, wobei die Leistungsschaltungsplatine (1) ferner Stromsensoren (15) umfasst, und die Stromsensoren (15) auf den zweiten elektrisch leitenden Strukturen (132) in einer umhüllenden Weise angeordnet sind.

4. Motorsteuereinheit nach Anspruch 1, ferner umfassend eine erste wärmeleitende und isolierende Unterlage, wobei die erste wärmeleitende und isolierende Unterlage zwischen dem Kühlkörper (2) und der Leistungsschaltungsplatine (1) angeordnet ist.

5. Motorsteuereinheit nach Anspruch 8, wobei die ersten Laschen (31) mit ersten Befestigungslöchern (311) versehen sind, und die zweiten Laschen (32) mit zweiten Befestigungslöchern (321) versehen sind; die vierten elektrisch leitenden Strukturen (142) mit dritten Befestigungslöchern (1421) versehen sind;
die ersten Kupferstangen (14A) durch Schrauben, die die ersten Befestigungslöcher (311) und die dritten Befestigungslöcher (1421) durchdringen, an den ersten Laschen (31) befestigt sind; und
die zweiten Kupferstangen (14B) durch Schrauben, die die zweiten Befestigungslöcher (321) und die dritten Befestigungslöcher (1421) durchdringen, an den zweiten Laschen (32) befestigt sind.

6. Fahrzeug, umfassend die Motorsteuereinheit nach einem der Ansprüche 1-5.

## Revendications

1. Unité de commande de moteur, comprenant une carte de circuit de puissance (1), dans laquelle la carte de circuit de puissance (1) comprend une carte de circuit (11) et une pluralité de bras de pont (12) ; la carte de circuit (11) comprend une surface de montage et une surface non-montage qui sont disposées de manière opposée, et la pluralité de bras de pont (12) sont disposés sur un plan où se trouve la surface de montage ;
chacun des bras de pont (12) comprend un bras de pont supérieur (121) et un bras de pont inférieur (122), et chacun des bras de pont supérieurs (121) et chacun des bras de pont inférieurs (122) comprend une pluralité de tubes de puissance discrets ;
la carte de circuit de puissance (1) comprend en outre une pluralité de premières barres de cuivre (14A) et une pluralité de deuxièmes barres de cuivre (14B) qui sont noyées dans la carte de circuit (11) ; les premières barres de cuivre (14A) correspondent aux bras de pont supérieurs (121), et la première barre de cuivre (14A) est électriquement connectée à des premiers pôles de la pluralité de tubes de puissance dans le même bras de pont supérieur (121) ; les deuxièmes barres de cuivre (14B) correspondent une à une aux bras de pont inférieurs (122), et la deuxième barre de cuivre (14B) est électriquement connectée à des deuxièmes pôles de la pluralité de tubes de puissance dans le même bras de pont inférieur (122) ; et
la carte de circuit de puissance (1) comprend en outre une barre de cuivre de phase U (131U), une barre de cuivre de phase V (131V) et une barre de cuivre de phase W (131W) qui sont noyées dans la carte de circuit (11) et configurées pour délivrer un courant alternatif triphasé ;
l'unité de commande de moteur comprenant en outre un radiateur (2), dans laquelle le radiateur (2) est disposé d'un côté de la carte de circuit (11) éloigné des bras de pont (12) ; et des surfaces inférieures des premières barres de cuivre (14A), des surfaces inférieures des deuxièmes barres de cuivre (14B), une surface inférieure de la barre de cuivre de phase U (131U), une surface inférieure de la barre de cuivre de phase V (131V) et une surface inférieure de la barre de cuivre de phase W (131W) font toutes face au radiateur (2) et sont situées dans un même plan que la surface non-montage de la carte de circuit (11) ;
l'unité de commande de moteur comprenant en outre un condensateur (3), dans laquelle le condensateur (3) est disposé d'un côté du radiateur (2) éloigné de la carte de circuit de puissance (1), et le condensateur (3) est un condensateur à film mince intégré (3) ;
dans laquelle un côté d'un boîtier du condensateur à film mince intégré (3) est pourvu d'une pluralité de premières pattes saillantes (31) et d'une pluralité de deuxièmes pattes saillantes (32), les premières pattes (31) sont électriquement connectées à une première extrémité du condensateur à film mince intégré (3), et les deuxièmes pattes (32) sont électriquement connectées à une deuxième extrémité du condensateur à film mince intégré (3) ;
chacune des premières barres de cuivre (14A) et des deuxièmes barres de cuivre (14B) comprend une troisième structure électriquement conductrice (141) et une quatrième structure électriquement conductrice (142) qui sont formées d'un seul tenant ; les troisièmes structures électriquement conductrices (141) sont au moins partiellement noyées dans la carte de circuit (11), et les quatrièmes structures électriquement conductrices (142) sont exposées à l'extérieur de la carte de circuit (11) ;
les premières barres de cuivre (14A) correspondent une à une aux premières pattes (31), et les quatrièmes structures électriquement conductrices (142) des premières barres de cuivre (14A) sont au moins partiellement en butée contre les premières pattes (31) ; et
les deuxièmes barres de cuivre (14B) correspondent une à une aux deuxièmes pattes (32), et les quatrièmes structures électriquement conductrices (142) des deuxièmes barres de cuivre (14B) sont au moins partiellement en butée contre les deuxièmes pattes (32).

2. Unité de commande de moteur selon la revendication 1, dans laquelle chacune de la barre de cuivre de phase U (131U), de la barre de cuivre de phase V (131V) et de la barre de cuivre de phase W (131W) comprend une première structure électriquement conductrice (131) et une deuxième structure électriquement conductrice (132) qui sont formées d'un seul tenant, et les premières structures électriquement conductrices (131) sont perpendiculaires aux deuxièmes structures électriquement conductrices (132) ; les premières structures électriquement conductrices (131) sont au moins partiellement noyées dans la carte de circuit (11), et les deuxièmes structures électriquement conductrices (132) sont exposées à l'extérieur de la carte de circuit (11) ; et les deuxièmes structures électriquement conductrices (132) sont pourvues de premiers trous filetés (1321), et les deuxièmes structures électriquement conductrices (132) sont électriquement connectées à des boulons d'un moteur électrique au moyen des premiers trous filetés (1321).

3. Unité de commande de moteur selon la revendication 2, dans laquelle la carte de circuit de puissance (1) comprend en outre des capteurs de courant (15), et les capteurs de courant (15) sont disposés sur les deuxièmes structures électriquement conductrices (132) de manière enveloppante.

4. Unité de commande de moteur selon la revendication 1, comprenant en outre une première plaque thermoconductrice et isolante, dans laquelle la première plaque thermoconductrice et isolante est située entre le radiateur (2) et la carte de circuit de puissance (1).

5. Unité de commande de moteur selon la revendication 8, dans laquelle les premières pattes (31) sont pourvues de premiers trous de fixation (311), et les deuxièmes pattes (32) sont pourvues de deuxièmes trous de fixation (321) ; les quatrièmes structures électriquement conductrices (142) sont pourvues de troisièmes trous de fixation (1421) ;
les premières barres de cuivre (14A) sont fixées aux premières pattes (31) au moyen de boulons traversant les premiers trous de fixation (311) et les troisièmes trous de fixation (1421) ; et
les deuxièmes barres de cuivre (14B) sont fixées aux deuxièmes pattes (32) au moyen de boulons traversant les deuxièmes trous de fixation (321) et les troisièmes trous de fixation (1421).

6. Véhicule, comprenant l'unité de commande de moteur selon l'une quelconque des revendications 1 à 5.
